# EUROPEAN PATENT SPECIFICATION

(11) **EP 2 761 648 B1**
(45) Date of publication and mention of the grant of the patent: **10.06.2020**
(21) Application number: 11873309.6
(22) Date of filing: 30.09.2011
(51) Int. Cl.: H01L 21/336, H01L 21/8234, H01L 21/8238

(54) **NON-PLANAR TRANSISTOR FIN FABRICATION**
HERSTELLUNG EINER RIPPE FÜR EINEN NICHTPLANAREN TRANSISTOR
FABRICATION D'AILETTE DE TRANSISTOR NON PLAN

(43) Date of publication of application: 06.08.2014
(73) Proprietor: Intel Corporation, Santa Clara, CA 95054 (US)
(72) Inventor: JOSHI, Subhash M., Hillsboro, OR 97124 (US); HATTENDORF, Michael, Santa Clara, CA 95054 (US)
(74) Representative: Goddar, Heinz J.
(86) International application number: PCT/US2011/054459
(87) International publication number: WO 2013/048513

(56) References cited:
- WO-A1-01/39273
- JP-A- S5 932 125
- US-A1- 2004 119 100
- US-A1- 2005 277 211
- US-A1- 2006 033 095
- US-A1- 2009 325 106
- US-A1- 2010 155 844
- US-A1- 2011 101 455
- US-B1- 6 913 872
- US-B2- 7 329 913
- US-B2- 7 494 832
- US-B2- 7 701 008
- COLLAERT N ET AL: "Integration challenges for multi-gate devices", INTEGRATED CIRCUIT DESIGN AND TECHNOLOGY, 2005. ICICDT 2005. 2005 INTE RNATIONAL CONFERENCE ON AUSTIN, TX, USA MAY 9-11, 2005, PISCATAWAY, NJ, USA,IEEE, 9 May 2005 (2005-05-09), pages 187-194, XP010832277, DOI: 10.1109/ICICDT.2005.1502627 ISBN: 978-0-7803-9081-2
- ANABELA VELOSO ET AL: "Multi-Gate Fin Field-Effect Transistors Junctions Optimization by Conventional Ion Implantation for (Sub-)22 nm Technology Nodes Circuit Applications", JAPANESE JOURNAL OF APPLIED PHYSICS, JAPAN SOCIETY OF APPLIED PHYSICS, JP, vol. 50, no. 4.2, 1 April 2011 (2011-04-01), pages 4DC16-1, XP001573545, ISSN: 0021-4922, DOI: 10.1143/JJAP.50.04DC16 [retrieved on 2011-04-20]

## Description

### BACKGROUND

Embodiments of the present description generally relate to the field of microelectronic device fabrication and, more particularly, to the fabrication of non-planar transistors.

US 2005/0277211 A1 discloses a semiconductor optical device and a method for forming thereof A semiconductor device comprises a patterned masking layer which masks two fins while exposing one fin. The patterned masking layer is a nitride or an oxide layer and conventional deposition and patterning techniques may be used to form the patterned masking layer. After the formation of the patterned masking layer an implant may be performed into a semiconductor portion of the exposed fin.

US 2004/0119100 A1 discloses a MOS device with first and second freestanding semiconductor bodies formed on a substrate. The first freestanding semiconductor body has a first portion thereof disposed at a non-orthogonal, non-parallel orientation with respect to a first portion of a second freestanding semiconductor body.

US 2009/0325106 A1 discloses a semiconductor fabrication method that includes forming a patterned mask by spincoating a developable hard mask layer and a resist layer over a semiconductor substrate. Subsequently, the resist layer is exposed and developed to form a patterned resist layer where the development step also removes the underlying hard mask layer, thereby forming a patterned mask which defines a void or printed feature to expose a region over the semiconductor substrate which may be implanted, etched or otherwise processed.

US 2010/0155844 A1 discloses a semiconductor device including a pMOS transistor and an nMOS transistor formed by using an SOI substrate. Lithography is used to form a mask that covers a p-type region, second gate electrode material and a second mask. The first mask and the second mask are then used as a mask to obliquely implant a p-type impurity into the side of the n-type region so as to form an extension region in the n-type region. After the first mask is removed, lithography is used to form a third mask that covers the n-type region, first gate electrode material and the second mask. The third mask and the second mask are then used as a mask to obliquely implant an n-type impurity into the side of the p-type region so as to form an extension region in the p-type region.

The invention is defined in independent claim 1. Embodiments of the invention are defined in the dependent claims.

### BRIEF DESCRIPTION OF THE DRAWINGS

The subject matter of the present disclosure is particularly pointed out and distinctly claimed in the concluding portion of the specification. The foregoing and other features of the present disclosure will become more fully apparent from the following description and appended claims, taken in conjunction with the accompanying drawings. It is understood that the accompanying drawings depict only several embodiments in accordance with the present disclosure and are, therefore, not to be considered limiting of its scope. The disclosure will be described with additional specificity and detail through use of the accompanying drawings, such that the advantages of the present disclosure can be more readily ascertained, in which:
FIG. 1 is a perspective view of non-planar transistors;
FIG. 2 illustrates a top plan view of a technique of implanting non-planar transistor fins, as known in the art.
FIG. 3 illustrates a side cross-sectional view of a technique of implanting non- planar transistor fins, as known in the art.
FIG. 4 illustrates a side cross-sectional view of depositing a conformal blocking layer on a plurality of non-planar transistor fin, according to an embodiment of the present description.
FIG. 5 illustrates a side cross-sectional view of a portion of the conformal blocking layer of FIG. 4 having been removed and the exposed non-planar transistor fins being implanted with a dopant, according to an embodiment of the present description.
FIG. 6 is flow diagram of a process of using a conformal block layer to implant selected non-planar transistor fins according to an embodiment of the present description.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. References within this specification to "one embodiment" or "an embodiment" mean that a particular feature, structure, or characteristic described in connection with the embodiment is included in at least one implementation encompassed within the present invention. Therefore, the use of the phrase "one embodiment" or "in an embodiment" does not necessarily refer to the same embodiment. In addition, it is to be understood that the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims. In the drawings, like numerals refer to the same or similar elements or functionality throughout the several views, and that elements depicted therein are not necessarily to scale with one another, rather individual elements may be enlarged or reduced in order to more easily comprehend the elements in the context of the present description.

In the fabrication of non-planar transistors, such as tri-gate transistors and FinFETs, non-planar semiconductor bodies may be used to form transistors capable of full depletion with very small gate lengths (e.g., less than about 30 nm). These semiconductor bodies are generally fin-shaped and are, thus, generally referred to as transistor "fins". For example in a tri-gate transistor, the transistor fins have a top surface and two opposing sidewalls formed on a bulk semiconductor substrate or a silicon-on-insulator substrate. A gate dielectric may be formed on the top surface and sidewalls of the semiconductor body and a gate electrode may be formed over the gate dielectric on the top surface of the semiconductor body and adjacent to the gate dielectric on the sidewalls of the semiconductor body. Thus, since the gate dielectric and the gate electrode are adjacent to three surfaces of the semiconductor body, three separate channels and gates are formed. As there are three separate channels formed, the semiconductor body can be fully depleted when the transistor is turned on. With regard to finFET transistors, the gate material and the electrode only contact the sidewalls of the semiconductor body, such that two separate channels are formed (rather than three in tri-gate transistors).

Embodiments of the present description relate to the doping of fins within non-planar transistors, wherein a conformal blocking material layer may be used to achieve a substantially uniform doping throughout the non-planar transistor fins.

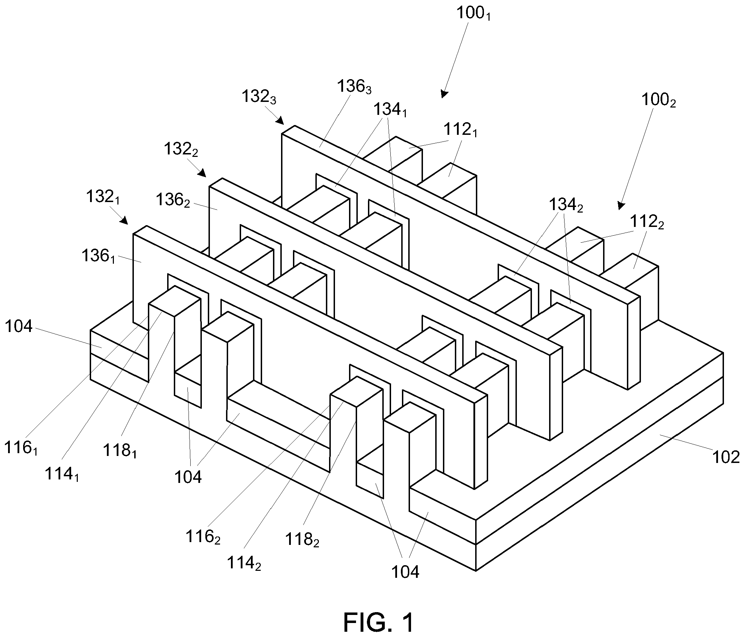

FIG. 1 is a perspective view of a number of non-planar transistors 100₁ and 100₂ (shown as "sets"), including a number gates formed on transistor fins, which are formed on a substrate. In an embodiment of the present disclosure, a substrate 102 may be a monocrystalline silicon substrate. The substrate 102 may also be other types of substrates, such as silicon-on-insulator ("SOI"), germanium, gallium arsenide, indium antimonide, lead telluride, indium arsenide, indium phosphide, gallium arsenide, gallium antimonide, and the like, any of which may be combined with silicon.

Each of the non-planar transistors 100₁ and 100₂, shown as tri-gate transistors, includes transistor fins 112₁ and 112₂ which may have isolation regions 104, such as silicon oxide (SiO₂), between each of the transistor fins 112₁ and 112₂ as well as between the non-planar transistors 100₁ and 100₂ themselves. The isolation regions 104 may be formed by any known fabrication process, as will be understood to those skilled in the art.

Each of the transistor fins 112₁ and 112₂ may have a top surface 114₁ and 114₂ and a pair of laterally opposite sidewalls, sidewalls 116₁ and 116₂ and opposing sidewall 118₁ and 118₂, respectively.

As further shown in FIG. 1, at least one transistor gate 132₁, 132₂, 132₃ may be formed over each of the transistor fins 112₁ and 112₂, respectively. The transistor gates 132₁, 132₂, 132₃ may be fabricated by forming gate dielectric layers 134₁ and 134₂ on or adjacent to the transistor fin top surfaces 114₁ and 114₂ and on or adjacent to the transistor fin sidewalls 116₁ and 116₂ and the opposing transistor fin sidewalls 118₁ and 118₂. Gate electrodes 136₁, 136₂, 136₃ may be formed on or adjacent the gate dielectric layers 134₁ and 134₂, respectively. In one embodiment of the present disclosure, the transistor fins 112₁ and 112₂ run in a direction substantially perpendicular to the transistor gates 132₁, 132₂, 132₃, respectively.

The gate dielectric layers 134₁ and 134₂ may be formed from any well-known gate dielectric material, including but not limited to silicon dioxide (SiO₂), silicon oxynitride (SiOₓN_{y}), silicon nitride (Si₃N₄), and high-k dielectric materials such as hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. The gate dielectric layers 134₁ and 134₂ can be formed by well-known techniques, such as by depositing a gate electrode material, such as chemical vapor deposition ("CVD"), physical vapor deposition ("PVD"), atomic layer deposition ("ALD"), and then patterning the gate electrode material with well-known photolithography and etching techniques, as will be understood to those skilled in the art.

The gate electrodes 136₁, 136₂, 136₃ can be formed of any suitable gate electrode material. In an embodiment of the present disclosure, the gate electrodes 136₁, 136₂, 136₃ may be formed from materials that include, but are not limited to, polysilicon, tungsten, ruthenium, palladium, platinum, cobalt, nickel, hafnium, zirconium, titanium, tantalum, aluminum, titanium carbide, zirconium carbide, tantalum carbide, hafnium carbide, aluminum carbide, other metal carbides, metal nitrides, and metal oxides. The gate electrodes 136₁, 136₂, 136₃ can be formed by well-known techniques, such as by blanket depositing a gate electrode material and then patterning the gate electrode material with well-known photolithography and etching techniques, as will be understood to those skilled in the art.

A source region and a drain region (not shown) may be formed in the transistor fins 112₁ and 112₂ on opposite sides of the gate electrodes 136₁, 136₂, 136₃, respectively. The source and drain regions may be formed by doping the transistor fins 112₁ and 112₂. As will be understood to those skilled in that art, doping is a process of introducing impurities into semiconducting materials for the purpose changing its conductivity and electronic properties. This is generally achieved by ion implantation of either P-type ions (e.g. boron) or N-type ions (e.g. phosphorus), collectively called "dopants".

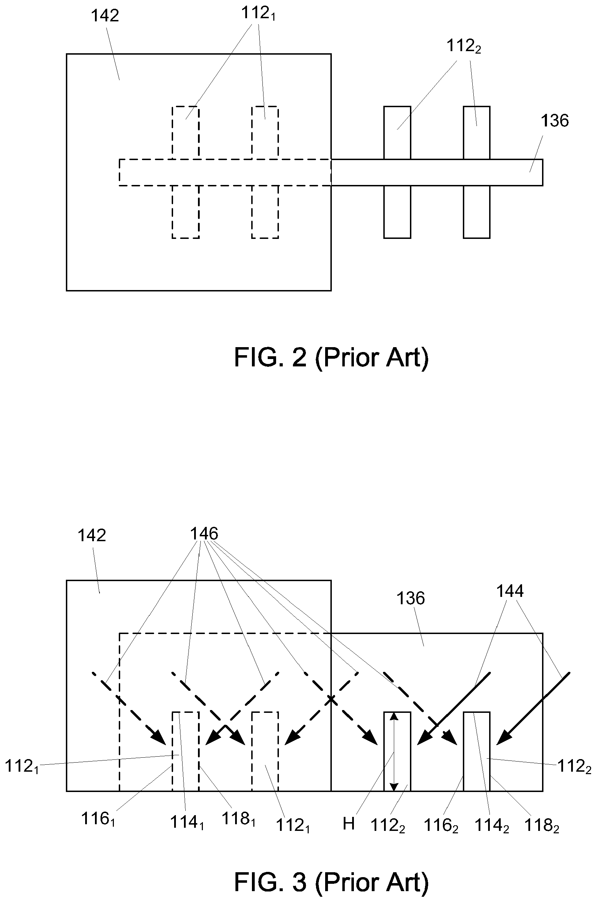

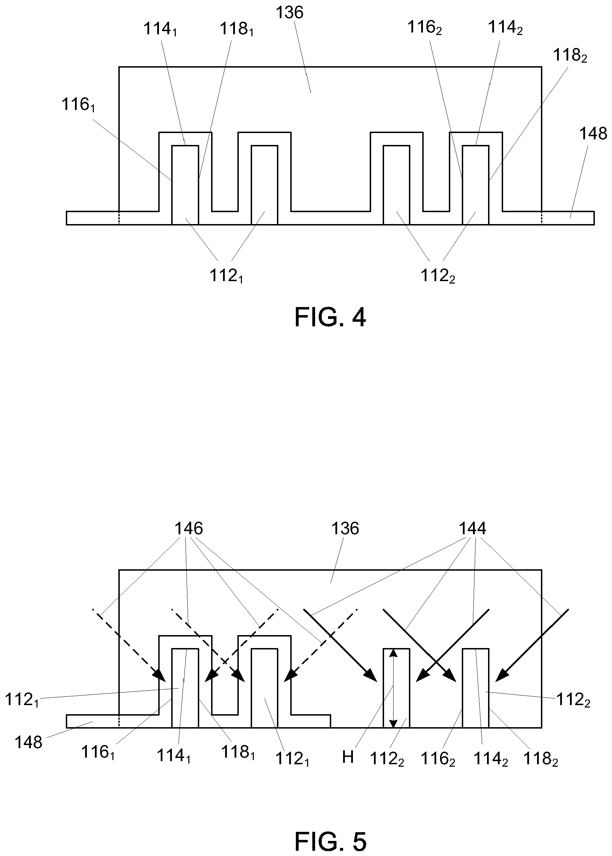

In order to achieve a uniform doping along a height H (see FIG. 3) of the transistor fins 112₁ and 112₂, the dopants may be implanted into the transistor fins 112₁ and 112₂ at an angle (shown as arrows 144 and 146 of FIGs. 3 and 5) from either side of the transistor fins 112₁ and 112₂ (e.g. toward sidewalls 116₁/116₂ and toward sidewalls 118₁/118₂). By implanting the dopants at an angle from either side of the transistor fins 112₁ and 112₂, the dopants are primarily implanted through the laterally opposite sidewalls pairs, e.g. the transistor fin sidewalls 116₁ and 118₁ and opposing transistor fin sidewalls 116₂ and 118₂ (see FIG. 1). As will be understood to those skilled in the art, identical implantation from each side of the transistor fins 112₁ and 112₂, may achieve uniform doping across the height H (see FIG. 3) of the transistor fins 112₁ and 112₂, which may be critical for optimal performance of the non-planar transistors (e.g. non-planar transistors 100₁ and 100₂ of FIG. 1). It is understood that the implantation may be perpendicular to the substrate 102, i.e. substantially directly into the transistor fin top surface 114₁ and 114₂.

As shown in FIGs. 2 and 3, in a convention process of implanting an dopant, areas which are not to be implanted with a dopant (shown as transistor fins 112₁) may be covered with a relatively thick layer of blocking material 142, such as a photoresist material. For the sake of clarity, neither the isolation regions 104 nor the substrate 102, as shown in FIG. 1, are illustrated in FIGs. 2 and 3, and the gate electrode is labeled simply as element 136.

The blocking material layer 142 may be formed with a known deposition and lithography techniques, wherein the blocking material layer 142 may be deposited over all of entire structure, which is followed by the formation of an etch mask with a lithographic technique and the portions of the blocking material layer 142 are etched away to expose desired areas (i.e., the transistor fins 112₂). However, although the blocking material layer 142 may successfully block the implantation of the transistor fins 112₁, the relative thickness of the blocking material layer 142 may also shadow and block some of the implantation to the transistor fins 112₂ where the implantation is desired. The blocked ion implantation is illustrated as dashed arrows 146. The non-blocked ion implantation is illustrated as solid arrows 144.

As it can be seen in FIG. 3, the partial blocking of the implantation (i.e. arrows 146) of the transistor fins 112₂ may result in an undesired non-uniform doping along the height H of the transistor fins 112₂. One solution to this issue would be to use greater spacing between the exposed and unexposed areas such that blocking of the implantation to the transistor fins 112₂ would not occur. However, such a solution is at contrary to the desire to continually scale down the size of microelectronic devices, as will be understood to those skilled in the art.

FIGs. 4 and 5 illustrate one embodiment of the present description. As shown in FIG. 4, a blocking layer 148 may be conformally deposited over the transistor fins 112₁ and 112₂. As will be understood to those skilled in the art, conformal deposition will result in the conformal blocking material layer 148 having substantially the same thickness on the surfaces of the transistors fins 112₁ and 112₂ (e.g. on the top surface 114₁ and the sidewalls 116₁ and 118₁, and on the top surface 114₂ and the sidewalls 116₂ and 118₂, respectfully). For the sake of clarity, neither the isolation regions 104 nor the substrate 102, as shown in FIG. 1, are illustrated in FIGs. 4 and 5, and the gate electrode is labeled simply as element 136.

The conformal blocking material layer 148 may comprise any material capable of blocking the implantation of a selected dopant. In one embodiment, the conformal blocking material layer 148 may be a dielectric material, including but not limited to silicon dioxide, silicon nitride, silicon carbide, silicon oxynitride, silicon oxycarbide, silicon cyanide, and silicon oxycyanide. As will be understood, other materials such as metals, including atomic layer deposited titanium nitride, may also be used as the conformal blocking material layer 148. The conformal blocking material layer 148 may be formed with a known conformal deposition technique, including but not limited to chemical vapor deposition ("CVD"), atomic layer deposition ("ALD"), and the like. It is understood that the conformal blocking material layer 148 should be sufficiently thick to block the implant material. In one embodiment, the conformal blocking material layer 148 may be greater than about 2nm. Additionally, the conformal blocking material layer 148 should be thin enough to form a conformal layer between the transistor fins (e.g. elements 114₁ and 114₂). For example, if the transistor fins are 40nm apart, then the conformal blocking material 148 should be less than about 20nm in thickness.

As shown in FIG. 5, a portion of the conformal blocking material layer 148 may be removed to expose desired transistor fins for implantation (e.g. transistor fins 112₂). This may be achieved by the formation of an etch mask with a lithographic technique and etching away the selected portions of the conformal blocking material layer 148, as will be understood to those skilled in the art.

As it can be seen in FIG. 5, the conformal blocking material layer 148 allows for uniform doping along the height H of the transistor fins 112₂, as the dopant ions can be evenly implanted from both sides for the transistor fins 112₂ (e.g. toward sidewalls 116₁/116₂ and toward sidewalls 118₁/118₂). The blocked implantation is illustrated as dashed arrows 146, and non-blocked implantation is illustrated as solid arrows 144.

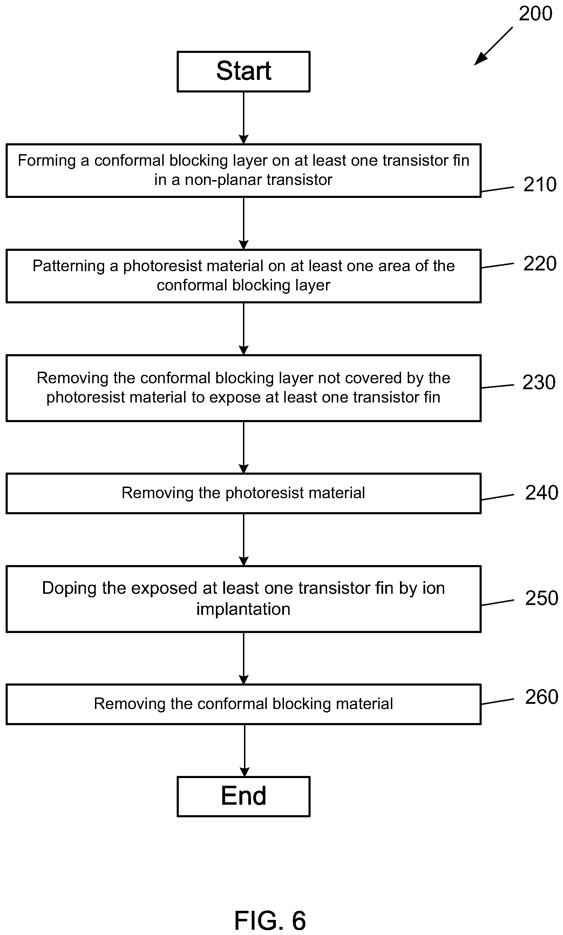

An embodiment of one process of using a conformal blocking material layer 148 during dopant ion implantation is illustrated in a flow diagram 200 of FIG. 6. As defined in block 210, a conformal blocking layer may be formed on transistor fins in a non-planar transistor. A photoresist material may be patterned in at least one area on the conformal blocking layer, as defined in block 220. As defined in block 230, the conformal blocking layer may be removed, such as by etching, in at least one area not covered by the photoresist material to expose at least one transistor fin to be doped by ion implantation. The photoresist material may be removed, as defined in block 240. As defined in block 250, the at least one transistor fin may then be doped by ion implantation. The conformal blocking material layer may then be removed, as defined in block 260.

It is understood that the subject matter of the present description is not necessarily limited to specific applications illustrated in FIGs. 4 and 5. The subject matter may be applied to other microelectronic device fabrication applications, as will be understood to those skilled in the art. Furthermore, the subject matter may also be used in any appropriate application outside of the microelectronic device fabrication field.

Having thus described in detail embodiments of the present invention, it is understood that the invention defined by the appended claims is not to be limited by particular details set forth in the above description.

## Claims

1. A method for fabricating non-planar transistors, comprising:
forming (210) a non-planar transistor having a plurality of transistor fins (112);
forming a conformal blocking material layer (148) on the plurality of transistor fins such that at least one of the plurality of transistor fins is covered by the conformal blocking material layer for blocking implantation thereof and at least one of the plurality of transistor fins is not covered by the conformal blocking material layer; and
performing (250) an angled ion implantation on opposing sidewalls of the at least one transistor fin not covered by the conformal blocking material layer.

2. The method of claim 1, wherein forming (220) the conformal blocking material layer comprises:
depositing the conformal blocking material layer on the plurality of transistor fins; and
removing a portion of the conformal blocking material layer to expose at least one of the plurality of transistor fins.

3. The method of claim 2, wherein removing a portion of the conformal blocking material layer to expose at least one of the plurality of transistor fins, comprises:
patterning (220) a photoresist material on at least one portion of the conformal blocking material layer; and
etching the conformal blocking material layer in areas not covered by the photoresist material.

4. The method of claim 1, further comprising removing (260) the conformal blocking material layer.

## Patentansprüche

1. Verfahren zum Fertigen von nichtplanaren Transistoren, das Folgendes umfasst:
Bilden (210) eines nichtplanaren Transistors mit mehreren Transistorfinnen (112);
Bilden einer konformen Blockiermaterialschicht (148) auf den mehreren Transistorfinnen, so dass wenigstens eine der mehreren Transistorfinnen durch die konforme Blockiermaterialschicht zum Blockieren einer Implantation davon bedeckt ist und wenigstens eine der mehreren Transistorfinnen nicht durch die konforme Blockiermaterialschicht bedeckt ist; und
Durchführen (250) einer schrägen Ionenimplantation an gegenüberliegenden Seitenwänden der wenigstens einen Transistorfinne, die nicht durch die konforme Blockiermaterialschicht bedeckt ist.

2. Verfahren nach Anspruch 1, wobei das Bilden (220) der konformen Blockiermaterialschicht Folgendes umfasst:
Abscheiden des konformen Blockiermaterials auf den mehreren Transistorfinnen; und
Entfernen eines Teils der konformen Blockiermaterialschicht, um wenigstens eine der mehreren Transistorfinnen freizulegen.

3. Verfahren nach Anspruch 2, wobei das Entfernen eines Teils der konformen Blockiermaterialschicht zum Freilegen wenigstens einer der mehreren Transistorfinnen Folgendes umfasst:
Strukturieren (220) eines Fotolackmaterials auf wenigstens einem Teil der konformen Blockiermaterialschicht; und
Ätzen der konformen Blockiermaterialschicht in Bereichen, die nicht durch das Fotolackmaterial bedeckt sind.

4. Verfahren nach Anspruch 1, das ferner Entfernen (260) der konformen Blockiermaterialschicht umfasst.

## Revendications

1. Procédé pour la fabrication de transistors non plans, comprenant :
la formation (210) d'un transistor non plan possédant une pluralité d'ailettes de transistor (112) ;
la formation d'une couche de matériau de blocage conforme (148) sur la pluralité d'ailettes de transistor de sorte qu'au moins une de la pluralité d'ailettes de transistor est couverte par la couche de matériau de blocage conforme pour le blocage d'une implantation de celle-ci et au moins une de la pluralité d'ailettes de transistor n'est pas couverte par la couche de matériau de blocage conforme ; et
la réalisation (250) d'une implantation ionique inclinée sur des parois latérales opposées de l'au moins une ailette de transistor non couverte par la couche de matériau de blocage conforme.

2. Procédé selon la revendication 1, la formation (220) de la couche de matériau de blocage conforme comprenant :
le dépôt de la couche de matériau de blocage conforme sur la pluralité d'ailettes de transistor ; et
l'élimination d'une partie de la couche de matériau de blocage conforme pour exposer au moins une de la pluralité d'ailettes de transistor.

3. Procédé selon la revendication 2, l'élimination d'une partie de la couche de matériau de blocage conforme pour exposer au moins une de la pluralité d'ailettes de transistor, comprenant :
la structuration (220) d'un matériau de type photorésine sur au moins une partie de la couche de matériau de blocage conforme ; et
la gravure de la couche de matériau de blocage conforme dans des zones non couvertes par le matériau de type photorésine.

4. Procédé selon la revendication 1, comprenant en outre l'élimination (260) de la couche de matériau de blocage conforme.
